Europäisches Patentamt

European Patent Office

Office européen des brevets

(11) Veröffentlichungsnummer: **0 378 186**

**A2**

(12) **EUROPÄISCHE PATENTANMELDUNG**

(21) Anmeldenummer: **90100418.4**

(22) Anmeldetag: **10.01.90**

(51) Int. Cl.⁵: **H03K 17/95, H03K 17/08**

(30) Priorität: **13.01.89 DE 3900801**

(43) Veröffentlichungstag der Anmeldung:
**18.07.90 Patentblatt 90/29**

(84) Benannte Vertragsstaaten:
**AT BE CH DE DK ES FR GB GR IT LI LU NL SE**

(71) Anmelder: **CHRISTIAN LOHSE**
**Berührungslose Schalttechnik GmbH**
**Knappenstrasse 152**
**D-5241 Katzwinkel/Betzdorf(DE)**

(72) Erfinder: **Kriz, Dieter**
**Hydenstrasse 7**
**D-5880 Lüdenscheid(DE)**

(74) Vertreter: **Patentanwaltsbüro Cohausz &**
**Florack**
**Postfach 14 01 20 Schumannstrasse 97**
**D-4000 Düsseldorf 1(DE)**

(54) **Ausgangsstufe für einen Wechselspannungsschalter, insbesondere Wechselspannungsnäherungsschalter.**

(57) Die Erfindung bezieht sich auf einen AC-Schalter, insbesondere AC-Näherungsschalter. Um die bei herkömmlichen Schaltern durch die Reihenschaltung eines Thyristors und einer Zener-Diode am Ausgang eines an der AC-Quelle liegenden Vollwellengleichrichters schlechte Schaltpunktstabilität zu verbessern, sind bei der Erfindung der Thyristor und die Zener-Diode durch ein MOS-FET T3 ersetzt, der durch eine von einer Eingangsstufe 1,2 angesteuerte Steuerstufe 3 angesteuert wird. Die Steuerstufe 3 steuert einen weiteren MOS-FET T4 eines Sourcefolgers T4,6 an, über den bei ausgeschaltetem Gleichrichter 4 die Eingangsstufe aus der AC-Quelle mit Spannung versorgt wird, während beim eingeschalteten Gleichrichter 4 für die Spannungsversorgung eine durch den MOS-FET T3 stabilisierte verhältnismäßig kleine Ausgangsspannung des Gleichrichters 4 verwendet wird, die wegen des durchgeschalteten MOS-FET T4 praktisch in voller Stärke an der Eingangsstufe 1,2 und der Steuerstufe 3 liegt. Wegen der stabilisierten kleinen Ausgangsspannung ist die Verlustleistung auch bei vergleichsweise großen Strömen klein, weshalb die temperaturabhängigen Bodenelemente, die für die Schaltpunktstabilität verantwortlich sind, nur vernachlässigbar wenig wärmebelastet sind. Mittels eines Stromsensors 8, der

Steuerstufe 3 und des MOS-FET T3 ist es bei jeder Phasenlage der Spannung der AC-Quelle möglich, im Falle eines zu großen Stromes, den Gleichrichter 4 zu sperren.

**Ausgangsstufe für einen Wechselspannungsschalter, insbesondere Wechselspannungsnäherungs-schalter**

Die Erfindung bezieht sich auf eine Ausgangs-stufe für einen Wechselspannungsschalter, insbe-sondere Wechselspannungs-Näherungsschalter, bei dem von einer Wechselspannnungs-Quelle eine Last über einen Gleichrichter gespeist wird, der von einer Eingangsstufe über eine Steuerstufe mit einem am Ausgang des Gleichrichters liegenden MOS-FET einschaltbar ist, wobei für die interne Spannungsversorgung der Eingangsstufe und der Steuerstufe bei nicht eingeschaltetem Gleichrichter die Eingangsstufe und die Steuerstufe über einen Source- oder Emitterfolger (T4,6) mit spannungs-stabilisiertem Eingang an der Wechselspannungs-quelle und bei eingeschaltetem Gleichrichter die Eingangsstufe und die Steuerstufe an einem spannungstabilisierenden, elektronischen Bauelement am Ausgang des Gleichrichters liegen.

Ausgangsstufen für Wechselspannungs-Schalter dieser Art werden meist mit der Netzwechselspannung betrieben, indem die beiden am Gleichrichter angeschlossenen Ausgangsleitungen über die Nutzlast, zum Beispiel ein Relais, eine Anzeigelampe oder dergleichen, am Netz liegen.

Bei einem aus der Praxis bekannten Wechselspannungs-Schalter ist der Gleichrichter mittels eines von der Steuerstufe angesteuerten Thyristors einschaltbar. Der Thyristor liegt in Reihe mit einer Z-Diode, an der bei eingeschaltetem Gleichrichter die interne Versorgungsspannung abgegriffen wird. Die an der Anode des Thyristers angeschlossene Z-Diode dient zur Spannungsstabilisierung der Versorgungsspannung. Bei nicht eingeschaltetem Gleichrichter erfolgt die interne Spannungsversorgung über einen am Ausgang des Gleichrichters angeschlossenen Sourcefolger aus dem Netz. Ein solcher Wechselspannungsschalter hat eine Reihe von Nachteilen.

Druckschriftlich sind allerdings auch solche Wechselspannungsschalter bekannt, bei denen statt des Thyristors ein MOS-FET eingesetzt ist (DE 31 46 709 C1; DE 35 36 925 A1).

Z-Dioden sind für die bei Wechselspannungsschaltern infrage kommenden Ströme von bis zu ca. 1 A nur bis zu einer minimalen Z-Spannung von ca. 5 V erhältlich. Bei einem durch die Z-Diode fließenden Ausgangsstrom des eingeschalteten Wechselspannungsschalters von nur 0,5 A entsteht eine Verlustleistung von ca. 2,5 W. Dadurch erwärmt sich der Wechselspannungsschalter mehr und mehr, wodurch sich seine Schaltabstände verändern. Hinzu kommt, daß Z-Dioden bezüglich ihrer Z-Spannung temperaturabhängig sind. Das bedeutet, daß sich die Ein- und Ausschaltpunkte des Wechselspannungsschalters wegen der an der Z-

Diode abgegriffenen internen Versorgungsspannung verschieben. Weiter wird die Schaltpunktstabilität dadurch verschlechtert, daß die Z-Spannung stromabhängig ist. Bei einem Ausgangsstrom des Wechselspannungsschalter von z.B. 20 mA ist die Z-Spannung ca. 20% geringer als bei 0,5 A. Darüber hinaus sind der große Platzbedarf der Z-Diode und die Tatsache von Nachteil, daß die Wärmeent-wicklung punktförmig konzentriert entsteht, wo-durch es zu örtlichen Beschädigungen im Schalterinneren kommen kann. Endlich beträgt der Spannungsabfall im durchgeschalteten Zustand an der Reihenschaltung von Thyristor und einer 5 V - Z-Diode ca. 8 V, der bei niedriger Netzspannung für manche Anwendungen zu hoch ist, um eine genügend große Versorgungsspannung zur Verfügung zu haben.

Neben diesen sich direkt aus dem Einsatz einer Z-Diode ergebenden Nachteilen besteht ein weiterer Nachteil des Wechselspannungsschalters darin, daß ein einmal gezündeter Thyristor frühestens beim nächsten Nulldurchgang der Betriebsspannung wieder abgeschaltet werden kann. Übersteigt der Ausgangsstrom während dieser Zeit, z.B. durch Kurzschluß der externen Last, den maximal zulässigen Wert, dann wird der Thyristor zerstört, und der Schalter ist nicht mehr betriebsbereit. Ein effektiver Kurzschlußschutz ist mit vertretbarem Aufwand nicht zu realisieren.

Der Erfindung liegt die Aufgabe zugrunde, einen Wechselspannungsschalter, insbesondere Wechselspannungs-Näherungsschalter, zu schaffen, der bezüglich seines Schaltverhaltens temperaturstabil ist. Darüber hinaus soll sich an ihm mit geringem Aufwand ein Kurzschlußschutz verwirklichen lassen. Endlich soll es auch möglich sein, mit geringem Aufwand ihn weitgehend unabhängig von der Größe der Netzspannung zu machen.

Diese Aufgabe wird erfindungsgemäß bei ei-nem Wechselspannungsschalter der eingangs ge-nannten Art dadurch gelöst, daß das spannungsstabilisierende Bauelement das am Ausgang des Gleichrichters liegende MOS-FET ist, und daß das FET oder der Transistor des Source- oder Emitterfolgers (T4,6) bei eingeschaltetem Gleichrichter von der Steuerstufe durchgeschaltet wird.

Bei dem erfindungsgemäßen Wechselspannungsschalter ist die Reihenschaltung aus Thyristor bzw. MOS-FET und Z-Diode des bekannten Wechselspannungsschalters durch ein MOS-FET ersetzt. Der FET hat die Eigenschaft einer temperaturstabilen idealen Z-Diode mit scharfem Knick, also einer sehr guten Spannungsstabilisierung für Ströme von 5 mA bis 500 mA. Da die am FET abfallende konstante Spannung nur 2 V beträgt, entsteht selbst bei 500 mA Ausgangsstrom nur 1 W Verlustleistung. Die Wärmeentwicklung ist also im Vergleich zur bekannten Schaltung mit Z-Diode um ein Mehrfaches geringer. Diese geringe Wärmeentwicklung selbst bei dem größten Ausgangsstrom garantiert, daß die temperaturempfindlichen Bauelemente des Wechselspannungs-Schalters nicht in einem Maße temperaturbelastet werden, daß es zu Schaltpunktverschiebungen kommt. Die bei eingeschaltetem Gleichrichter am FET anstehende stromunabhängige geringe konstante Spannung von ca. 2 V steht über dem von der Steuerstufe durchgeschalteten FET des Sourcefolgers sowohl bei hohen als auch bei niedrigen Netzspannungen als interne Versorgungsspannung der Eingangsstufe und der Steuerstufe zur Verfügung. Zu Schaltpunktverschiebungen kommt es auch nicht aufgrund verschieden großer Versorgungsspannungen der Eingangsstufe und der Steuerstufe bei eingeschaltetem und ausgeschaltetem Gleichrichter, wenn nach einer Ausgestaltung der Erfindung die Eingangsstufe über eine interne Spannungsstabilisierung verfügt. Der stromunabhängige, konstant niedrige Spannungsabfall am FET ist auch bei niedriger Netzspannung von Bedeutung, denn dadurch ist gewährleistet, daß der Last eine ausreichend große Spannung zur Verfügung steht.

Ein Kurzschlußschutz läßt sich leicht dadurch verwirklichen, daß am Ausgang des Gleichrichters ein Stromsensor der Steuerstufe liegt, die bei maximal zulässigem Strom des Gleichrichters diesen ausschaltet.

Im folgenden wird die Erfindung anhand eines Schaltbildes für einen Wechselspannungs-Näherungsschalter näher beschrieben.

Der Wechselspannungs-Näherungsschalter umfaßt als Eingangsstufe einen Oszillator 1 mit einer Auswertschaltung, die über eine interne Spannungsstabilisierung für eine Betriebsspannung von 3-10 V verfügt. Als Sensor für metallische Ziele weist der Oszillator 1 eine Spule eines Schwingkreises 2 auf. Der Ausgang des Oszillators 1 ist über eine zwei Transistoren T1,T2 umfassende Verstärker- und Impulsformerstufe mit dem Eingang einer Steuerstufe 3 gekoppelt, die als Spannungswandlerschaltung ausgebildet ist. Der Ausgang der Steuerstufe 3 liegt am Gate eines Leistungs-MOS-FET T3. Die Drain-Source-Strecke des MOS-FET T3 liegt in Reihe mit einem Widerstand $R_s$ zur Stromsensierung. Diese Reihenschaltung bildet den Brückenzweig eines Vollwellengleichrichters 4, der mit seinem Eingang über eine Last 5 an einer Wechselspannungsquelle, insbesondere dem Netz, liegt. Ein VDR-Widerstand liegt an den Anschlußklemmen des Gleichrichters 4, der zum Schutz des Schalters vor Spannungsspitzen dient.

An der Anschlußklemme des Brückenzweiges, an dem auch der MOS-FET T3 liegt, ist ein Sourcefolger T4,$R_v$,6 angeschlossen, deren Drain-Source-Strecke in Reihe mit einem Zweig des Gleichrichters 4 und der Last 5 an der Wechselspannungsquelle liegt. Am Gate des MOS-FET T4 ist zum einen eine Z-Diode 6 und zum anderen über eine Diode 7 ein Steuerausgang der Steuerstufe 3 angeschlossen.

An dem Sensorwiderstand $R_s$ ist ein Stromsensor 8 angeschlossen, der über eine Diode 9 an die Basis des Transistors T1 ein Signal liefert.

Die Arbeitsweise des Wechselspannungs-Näherungsschalters ist folgende:

Solange in der Nähe der Spule des Schwingkreises 2 sich kein magnetisierbares Ziel befindet, schwingt der Oszillator 1. Der Gleichrichter 4 ist dann ausgeschaltet. Der Oszillator 1 wird in dieser Phase über die Last 5, einen Zweig des Gleichrichters 4 und den FET T4 des Sourcefolgers aus dem Netz mit Strom versorgt. Die Versorgungsspannung am Oszillator 1 wird durch die Z-Diode 6 des Sourcefolgers auf ca. 5 V stabilisiert. Sobald in die Nähe der Spule des Schwingkreises 2 ein magnetisierbares Ziel gelangt, hört der Oszillator 1 auf zu schwingen. Sein Ausgangssignal steuert dann den Transistor T1 durch, wodurch wiederum der Transistor T2 durchgesteuert wird. Die Steuerstufe 3 steuert dann den MOS-FET T3 an, wodurch der Gleichrichter 4 eingeschaltet wird. Über die Last 5 fließt dann ein großer Strom, der bei einer als Relais ausgebildeten Last einen Schaltvorgang auslöst oder bei einer als Kontrollampe ausgebildeten Last die Kontrollampe aufleuchten läßt. Am MOS-FET T3 liegt dann die gewünschte stabilisierte niedrige Spannung von ca. 2 V an.

Gleichzeitig mit dem Durchschalten des MOS-FET T3 wird über die Diode 7 der MOS-FET T4 derart angesteuert, daß er durchschaltet. Als Spannungsversorgung steht dann sowohl am Oszillator 1 als auch an der Steuerstufe 3 die durch den MOS-FET T3 stabilisierte Ausgangsspannung des Gleichrichters 4 an. Der Wert des Widerstandes $R_s$ ist derart klein, daß der Spannungsabfall an diesem Widerstand $R_s$ im gesamten Strombereich im Vergleich zu dem Spannungsabfall am MOS-FET T3 vernachlässigbar klein ist.

Der Spannungsabfall am Widerstand $R_s$ wird vom Stromsensor 8 erfaßt. Überschreitet der Strom im Gleichrichter 4, zum Beispiel infolge eines Kurzschlusses, einen vorgegebenen maximalen Wert, dann wird durch ein Signal des Stromsensors 8 der Transistor T1 gesperrt. Das hat zur Folge, daß auch der MOS-FET T3 gesperrt wird. Nach einer gewissen Zeit wird bei andauerndem Signal des Oszillators 1 der MOS-FET T3 erneut durchgeschaltet. Sollte der Stromsensor 8 dann wieder einen zu hohen Stromwert messen, wird der Schalter wieder abgeschaltet. Dieser Vorgang wiederholt sich für die Dauer des Kurzschlusses immer wieder.

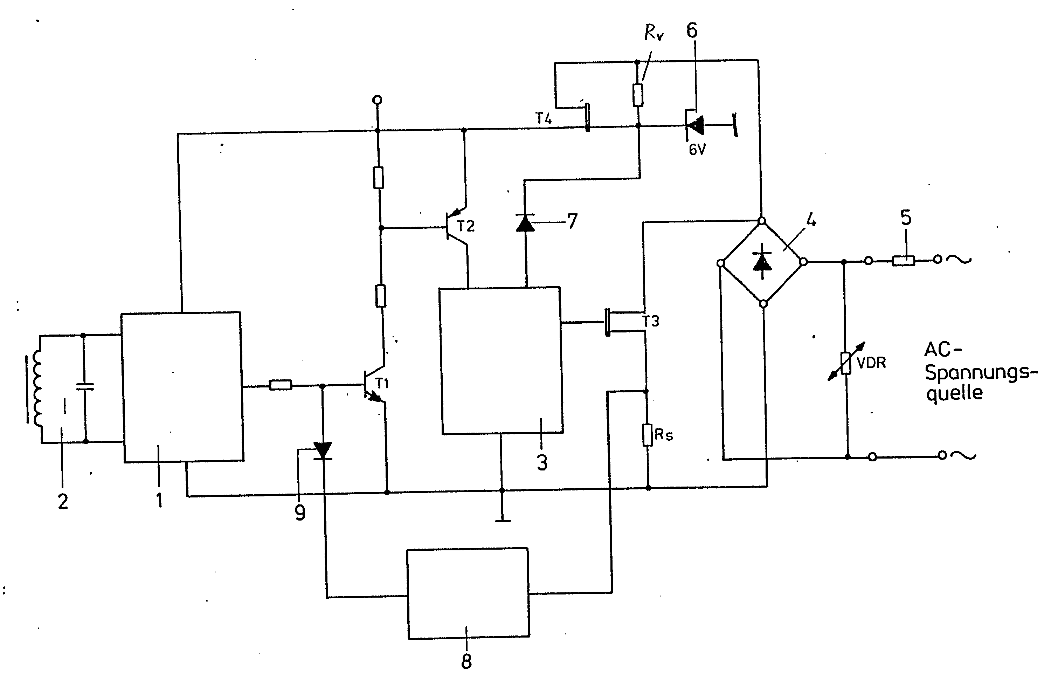

**Ansprüche**

1. Ausgangsstufe für einen Wechselspannungsschalter, insbesondere Wechselspannungs-Näherungsschalter, bei dem von einer Wechselspannungs-Quelle eine Last (5) über einen Gleichrichter (4) gespeist wird, der von einer Eingangsstufe (1,2) über eine Steuerstufe (3) mit einem am Ausgang des Gleichrichters (4) liegenden MOS-FET einschaltbar ist, wobei für die interne Spannungsversorgung der Eingangsstufe (1,2) und der Steuerstufe (3) bei nicht eingeschaltetem Gleichrichter (4) die Eingangsstufe (1,2) und die Steuerstufe (3) über einen Source- oder Emitterfolger (T4,6) mit spannungsstabilisiertem Eingang an der Wechselspannungsquelle und bei eingeschaltetem Gleichrichter (4) die Eingangsstufe (1,2) und die Steuerstufe (3) an einem spannungsstabilisierenden, elektronischen Bauelement (T3) am Ausgang des Gleichrichters (4) liegen,
dadurch gekennzeichnet, daß das spannungsstabilisierende Bauelement (T3) das am Ausgang des Gleichrichters (4) liegende MOS-FET ist, und daß das FET (T4) oder der Transistor des Source- oder Emitterfolgers (T4,6) bei eingeschaltetem Gleichrichter (4) von der Steuerstufe (3) durchgeschaltet wird.

2. Ausgangsstufe für einen Wechselspannungsschalter nach Anspruch 1,
dadurch gekennzeichnet, daß am Ausgang des Gleichrichters (4) ein Stromsensor (R$_s$,8) der Steuerstufe (3) liegt, die bei Überschreiten eines maximal zulässigen Stroms des Gleichrichters (4) diesen über das FET (T3) ausschaltet.

3. Ausgangsstufe für einen Wechselspannungsschalter nach Anspruch 1 oder 2,
dadurch gekennzeichnet, daß die Eingangsstufe (1,2) eine interne Spannungsstabilisierung aufweist.

AC-
Spannungsquelle